Europäisches Patentamt

European Patent Office

Office européen des brevets

(11) Veröffentlichungsnummer: **0 281 549 B1**

(12) **EUROPÄISCHE PATENTSCHRIFT**

(45) Veröffentlichungstag der Patentschrift: **13.07.94**

(51) Int. Cl.⁵: **H01J 37/30**, H01J 37/317, G03F 7/20

(21) Anmeldenummer: **88890043.8**

(22) Anmeldetag: **04.03.88**

(54) Einrichtung zur verkleinernden oder 1 : 1 Ionenprojektionslithographie.

(30) Priorität: **05.03.87 AT 507/87**

(43) Veröffentlichungstag der Anmeldung:
**07.09.88 Patentblatt 88/36**

(45) Bekanntmachung des Hinweises auf die
Patenterteilung:
**13.07.94 Patentblatt 94/28**

(84) Benannte Vertragsstaaten:
**AT BE CH DE FR GB IT LI NL SE**

(56) Entgegenhaltungen:

**NUCLEAR INSTRUMENTS & METHODS IN PHYSICS RESEARCH / SECTION B, Band B19/20, 3. Februar 1987, Teil II, Seiten 987-994, Elsevier Science Publishers B.V., Amsterdam, NL ; G. STENGL et al. : "Ion projection lithography for sub-micron modification of materials"**

**Ion Implantation, Band 8, Seiten 446-448, G. Dearnaley et al., North Holland Pub. Comp., 1973**

**Nucl. Instr. & Meth. in Physics Research, Band B6, 1985, S. 183-189, E. Miyauchi et al.**

**"Computer control of maskless ion implanter with Au-Si-Be LM ion source for II-V compound semiconductors"**

(73) Patentinhaber: **IMS Ionen Mikrofabrikations Systeme Gesellschaft m.b.H.
Schreygasse 3
A-1020 Wien(AT)**

Patentinhaber: **Österreichische Investitions- kredit Aktiengesellschaft
Renngasse 10
A-1013 Wien(AT)**

(72) Erfinder: **Stengl, Gerhard, Dr.
Umberg 41
A-9241 Wernberg Kärnten(AT)**

(74) Vertreter: **Casati, Wilhelm, Dipl.-Ing. et al
Patentanwälte Casati, Wilhelm, Dipl.-Ing.
Krause, Ernst, Dipl.-Ing.
Itze, Peter, Dipl.-Ing.
Amerlingstrasse 8
A-1061 Wien (AT)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Einrichtung zur verkleinernden oder 1 : 1 Ionenprojektionslithographie mit einer Ionenquelle, einer im Strahlengang angeordneten strukturierten Maske sowie einem Substrat, auf dem die Maskenstruktur abgebildet wird, wobei im Strahlengang, zwischen Maske und Substrat, eine Immersionslinse und eine beispielsweise als EINZEL-Linse ausgebildete Projektionslinse und weiters im System zur Massentrennung ein WIEN-Filter samt dazugehörender Blende, welche die unerwünschten Massen ausblendet, angeordnet sind. Ionenquellen liefern im Regelfall ein Gemisch von Ionen. So treten beispielsweise aus einer Ionenquelle für He, neben den erwünschten He-Ionen auch H-Ionen aus, die - je nach durchzuführender Abbildung - unerwünscht sein können.

Durch das Dokument Nuclear Instruments & Methods in Physics Research/Section B, Band B19/20, 3. Feber 1987, Teil II, Seiten 987 - 994, Elsevier Science Publishers B.V., Amsterdam, NL; G.Stengl et al.: "Ion projection lithography for submicron modification of materials" wurde es bekannt, in einer verkleinernden Ionenprojektionseinrichtung, in der die Struktur einer Maske mittels eines ionenoptischen Abbildungssystems auf ein Substrat projiziert wird, zur Massentrennung ein zwischen Ionenquelle und Maske angeordnetes WIEN-Filter vorzusehen. Das WIEN-Filter war zum Zeitpunkt des Erscheinens des Dokumentes in Entwicklung, so daß dem Dokument weder über die genaue Anordnung des Filters noch über die Anordnung der zugehörigen Blende im System genauere Angaben entnommen werden können. Im WIEN-Filter wirken gekreuzte elektrische und magnetische Felder, unter deren Wirkung unterschiedliche Ionen gleicher Energie unterschiedliche Ablenkung erfahren, wobei durch geeignete Einstellung des elektrischen und des magnetischen Feldes die Ionen der gewünschten Masse unabgelenkt hindurchtreten.

Miyauchi et al, Nucl.Instr. & Meth. in Physics Research B6, 183 (1985) beschreiben eine Einrichtung zur maskenlosen Ionenimplantation, bei der sich nach der Ionenquelle ein WIEN-Filter und unmittelbar dahinter eine Blende befindet.

Diese bekannte Einrichtung ist jedoch für das gegenständliche Projektionsverfahren schlecht geeignet, da die aus dem WIEN-Filter austretenden Strahlen divergent sind (Öffnungswinkel beispielsweise 6°). Um mit Hilfe der sich bei der bekannten Einrichtung unmittelbar nach dem WIEN-Filter befindlichen Blende ausgeblendet zu werden, müßten die Ionen mit unerwünschten Massen durch das WIEN-Filter sehr stark abgelenkt werden; dies impliziert jedoch hohe elektrische und magnetische Feldstärken am Wien-Filter, mit denen starke (inhomogene) Randfelder einhergehen, durch welche wiederum Verzerrungen bei der Abbildung einer Maske hervorgerufen werden würden.

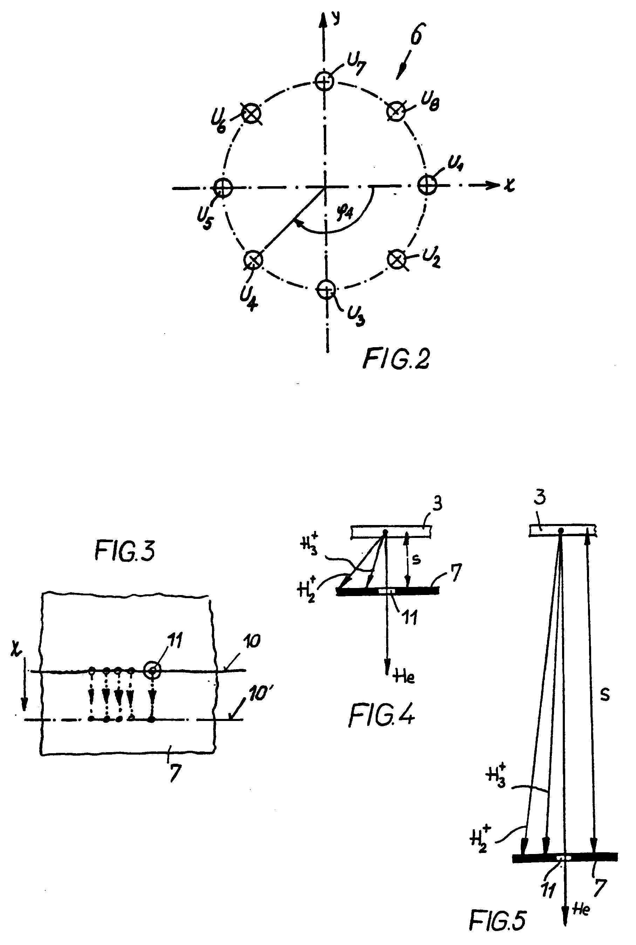

Eine weitere bekannte Einrichtung ist in "Ion Implantation", vol. 8, pp.446-448; Fig. 4.130 (G.Dearnaley et al., North Holland Publ., Comp., 1973) beschrieben. In dieser von M.Bernheim et al (4th Int.Conf.on Electron and Ion Beam Science and Technology, Los Angeles) vorgeschlagenen Anordnung ist ein gekrümmter Strahlengang ersichtlich, der - wie Bernheim ausführt - durch einen nach der Quelle angeordneten Magnet verursacht wird, welcher Ionen verschiedener Massen verschieden stark ablenken kann. Je nach Einstellung des Magnetfeldes werden dann immer nur Ionen mit einer bestimmten gewünschten Masse in das weitere Abbildungssystem gelangen. Diese Methode hat den gravierenden Nachteil, daß sich die Quelle nicht auf der optischen Achse des abbildenden Linsensystems befinden kann, da durch das Magnetfeld alle Ionen, auch die erwünschten, abgelenkt werden.

Aufgabe der Erfindung ist es, störende Randfelder zu vermeiden, die durch hohe für die bisnun erforderliche starke Ablenkung der aus dem WIEN-Filter austretenden Strahlen erforderlich waren und solcherart mit geringen Feldstärken am WIEN-Filter das Auslangen zu finden. Dabei können auch die Nachteile der beiden letztgenannten bekannten Methoden zur Massentrennung vermieden werden. Erreicht wird dies, wenn erfindungsgemäß die zu dem zwischen Ionenquelle und Maske angeordneten WIEN-Filter gehörende Blende zwischen Immersionslinse und Substrat in großem Abstand vom WIEN-Filter an einem Ort mit geringem Strahldurchmesser, nämlich an einer Stelle vor dem Kreuzungspunkt der aus der Immersionslinse austretenden Ionenstrahlen, z.B. mit einer Öffnung von 500 µm, angeordnet ist. Die Blendenöffnung kann bevorzugt kreisrund ausgeführt werden, kann jedoch auch Rechtecks- oder Quadratform aufweisen. Da sich in der erfindungsgemäßen Einrichtung die Blende an einem Ort mit geringem Strahldurchmesser, aber in großer Entfernung vom Wien-Filter, befindet, genügt es, die unerwünschten Massen um nur kleine Winkel abzulenken, um sie nicht mehr durch die Blende hindurchzulassen. Daher benötigt man nur geringe Feldstärken am Wien-Filter, sodaß die störenden Randfelder und die dadurch entstehenden Bildverzerrungen minimal und unter der Toleranzgrenze bleiben.

Die Erfindung erlaubt es auch, das Gasgemisch, mit dem die Ionenquelle gespeist wird, zu wechseln und dabei die Abbildung der Maskenstruktur auf das Substrat mit ein und derselben gewünschten Ionensorte durchzuführen.

Darüberhinaus erlaubt die erfindungsgemäße Einrichtung auch einen Übergang von einer Ionensorte auf eine andere Ionensorte des gleichen in der Ionenquelle aufgegebenen Mediengemisches, wobei ein und derselbe Wafer mit zwei oder mehr Ionensorten belichtet werden kann, ohne daß die Lage des Wafers (das Alignment) umgestellt werden müßte.

Eine Vereinfachung des Aufbaues der erfindungsgemäßen Einrichtung kann erzielt werden, wenn in weiterer Ausgestaltung des Erfindungsgegenstandes, die zum Wien-Filter gehörende Blende in die Projektionslinse integriert ist.

Eine weitere Ausgestaltung des Erfindungsgegenstandes kennzeichnet sich dadurch, daß zwischen Ionenquelle und dem WIEN-Filter eine, insbes. als EINZEL-Linse ausgebildete, elektrostatische Vorlinse zur Erzeugung konvergenter Strahlen, deren Kreuzungspunkt im WIEN-Filter liegt, angeordnet ist. Mittels der Vorlinse kann dabei die Ionenquelle etwa im Maßstab 1 : 1 bis 1 : 2 in die optische Achse des Wien-Filters abgebildet werden, wodurch die Bildfehler des Wien-Filters minimiert werden. Entfällt die Vorlinse, was durchaus praktikabel ist, so gelangen die Ionenstrahlen aus der Ionenquelle divergent in das Wien-Filter.

Gemäß einer weiteren Ausbildung des Erfindungsgegenstandes ist vorgesehen, daß im Strahlengang vor der zum Wien-Filter gehörenden Blende eine willkürlich aktivierbare, ein elektrostatisches Feld erzeugende Ablenkeinheit, z.B. ein Multipol, insbes. Oktopol, angeordnet ist. Durch Aktivieren der Ablenkeinheit können die durch das Wien-Filter nach ihren Massen aufgefächerten Ionen z.B. senkrecht zur Auffächerungsrichtung abgelenkt werden, sodaß keine Ionen mehr auf die Blende treffen. Dabei wird zwar die Maske weiter bestrahlt, was im Hinblick auf das Konstanthalten der Maskentemperatur erwünscht ist, jedoch werden die Strahlen vor Erreichen des Wafers ausgeblendet. Die elektrostatische Ablenkeinheit wirkt daher als Shutter, welcher allerdings nicht die Nachteile eines mechanischen Shutters, z.B. Erschütterungen und Zeitdauer für den Verschluß, aufweist. Bei Verwendung der elektrostatischen Ablenkeinheit ist daher bei einem auf ein Ausblenden folgenden Wiedereinschalten (d.h. Ausschalten der Ablenkeinheit) das Bild sofort an der richtigen Stelle, d.h. es bedarf keines neuerlichen Alignments, um das Bild nach einem erfolgten Ausblenden wieder an die gewünschte Stelle des Wafers zu projizieren.

Die Erfindung wird nachstehend anhand der Zeichnung beispielsweise näher erläutert. Es zeigen: Die

Fig. 1, 1a eine erfindungsgemäß ausgebildete verkleinernde Ionenprojektionslithographieeinrichtung in schematischer Darstellung,
Fig. 2, ebenfalls in schematischer Darstellung, ein Detail aus Fig. 1,

Fig. 3 die Wirkungsweise des in Fig. 2 dargestellten Details, die
Fig. 4 und 5 zwei unterschiedliche Blendenanordnungen bezüglich eines in der erfindungsgemäßen Ionenprojektionslithographieeinrichtung zur Anwendung gelangenden Filters, und
Fig. 6 die schematische Anordnung für die 1 : 1 Schattenprojektion.

In der Zeichnung ist mit 1 eine Ionenquelle einer Ionenprojektionseinrichtung bezeichnet. Im Strahlengang liegt weiters eine mit einer Struktur versehene Maske 4 sowie ein Substrat 9, auf dem die Struktur der Maske 4 durch Ionenprojektion abgebildet werden soll. Zwischen der Maske 4 und dem Substrat 9 sind eine Immersionslinse 5 zur Beschleunigung der Ionen auf die notwendige Endenergie und eine Projektionslinse 8 angeordnet. Diese Linse ist bevorzugt als Einzellinse ausgebildet. Die Immersionslinse 5 fokussiert das Bild der Ionenquelle 1 in die Projektionslinse 8. Die Ionenquelle 1 liefert einen divergenten Ionenstrahl 12 unterschiedlicher Ionensorten, von denen im allgemeinen jeweils nur eine für die Projektion erwünscht ist. So liefert etwa eine Quelle 1 für He-Ionen zusätzlich zu den He-Ionen auch noch $H^+$-, $H_2^+$- und $H_3^+$- Ionen, die nicht erwünscht sind, so daß zu verhindern ist, daß diese für die Projektion unerwünschten Ionen zum Substrat 9 gelangen. Um dies zu erreichen, wird vorgeschlagen, zwischen der Ionenquelle 1 und der Maske 4 ein (gekreuzte elektrische und magnetische Felder lieferndes) Wien-Filter 3 (ExB-Filter) und zwischen der Immersionslinse 5 und dem Substrat 9 eine Blende 7 zu positionieren. Aufgrund der Position der Blende braucht die Blendenöffnung nur etwa 500 $\mu$m zu betragen. Die Ionenquelle 1 liefert Ionenstrahlen 12, die am Austritt einen sehr geringen Durchmesser (von ca. 10 - 50 $\mu$m) besitzen. Die Größe des Durchmessers hängt von der gewünschten Auflösung ab. Angestrebt werden Auflösungen unter 1 $\mu$m. Die Blende 7 kann in die Projektionslinse 8 integriert sein.

Zwischen der Ionenquelle 1 und dem Wien-Filter 3 kann eine elektrostatische Vorlinse 2 angeordnet werden. Diese Vorlinse erzeugt konvergente Strahlen. Die Anordnung der Vorlinse 2 relativ zum Wien-Filter 3 erfolgt dabei so, daß der Kreuzungspunkt der aus der Vorlinse 2 kommenden Strahlen in der Mitte des Wien-Filters 3 liegt. Mittels der Vorlinse 2 kann (bei abgeschaltetem Wien-Filter 3) die virtuelle Quelle (d.i. das Bild, das die Vorlinse vor der Quelle erzeugt) auf die optische Achse der Projektionseinrichtung justiert werden.

Vor der Blende 7 und nach der Immersionslinse 5 kann in den Strahlengang eine willkürlich aktivierbare Ablenkeinheit 6 für die Ionenstrahlen eingebaut werden. Die Ablenkeinheit 6 dient zur Erzeugung eines elektrostatischen Feldes. Mittels dieses Feldes können die durch das Wien-Filter 3 in eine Ebene 10 (Fig. 3), welche die Öffnung 11 der Blende 7 schneidet, gelegten Strahlen aus dieser Ebene (in Richtung x) abgelenkt und damit aus dem Bereich der Öffnung 11 der Blende 7 (in die Ebene 10') verschoben werden. Da die Ablenkeinheit 6 im Strahlengang hinter der Maske 4 angeordnet ist, kann auch nach Aktivierung der Ablenkeinheit 6 und damit einhergehender Ausblendung des Bildes der Maskenstruktur am Substrat 9, die Maske 4 weiter von den Ionen bestrahlt werden, womit sie ihre Temperatur behält, und Verzerrungen der Struktur, wie sie bei einer Abkühlung der Maske auftreten können, vermieden werden.

Die Ablenkeinheit 6 kann als Oktopol ausgebildet werden. Ein diesbezügliches Ausführungsbeispiel ist schematisch in Fig. 2 dargestellt. In die Darstellung sind die Potentiale $U_1 \dots U_8$ der Pole eingetragen. Zur Erzeugung eines Dipolfeldes betragen hierbei beispielsweise:

$U_1 = U_o$, $U_2 = U_o/\sqrt{2}$, $U_3 = 0$, $U_4 = -U_o/\sqrt{2}$, $U_5 = U_o$, $U_6 = -U_o/\sqrt{2}$, $U_7 = 0$, $U_8 = U_o/\sqrt{2}$ ($U_i = U_o.\cos(-\phi)$),

wobei $U_o$ entsprechend der Ionenenergie und der gewünschten Verschiebung in x-Richtung gewählt wird.

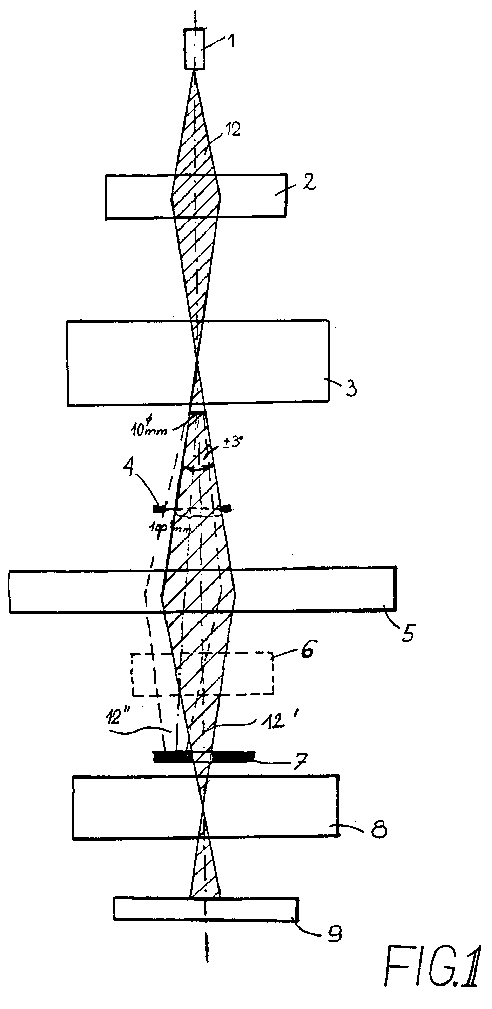

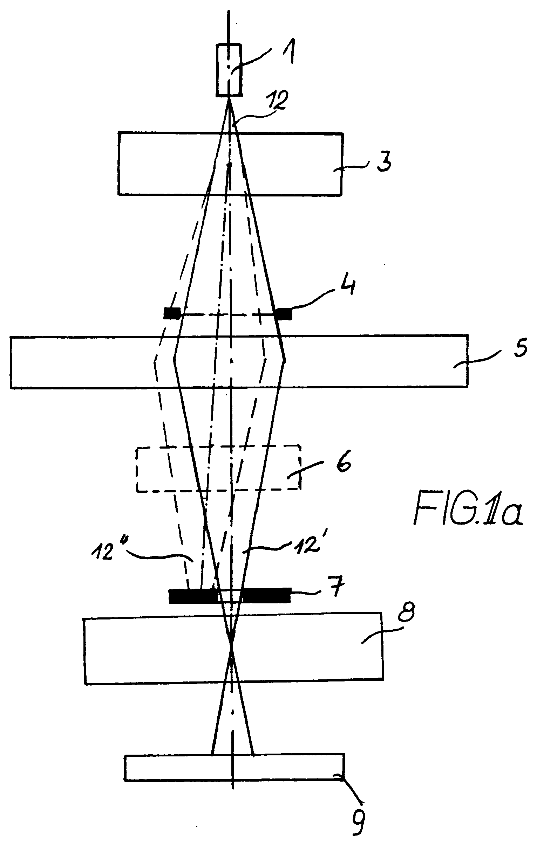

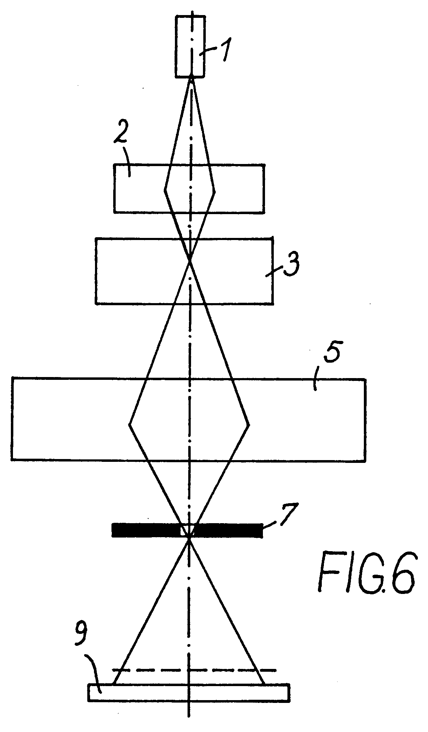

Im Wien-Filter 3 werden die Ionen - abhängig von ihrer Masse - unterschiedlich stark abgelenkt, wobei bei einer bestimmten Ionenenergie die Größe der Ablenkung von der elektrischen und magnetischen Feldstärke abhängig ist. Fig. 1 bzw. 1a zeigen schematisch den Strahlengang zweier Ionensorten 12', 12'' mit benachbarten Massen. Da mit größer werdenden Feldstärken im Wien-Filter 3 auch die Randfelder größer werden, wodurch eine Verzerrung der Abbildung hervorgerufen wird, ist es wünschenswert, die Feldstärken und damit die Ablenkungen möglichst gering zu halten. Die erfindungsgemäße Einrichtung erlaubt dies dadurch, daß die Blende 7 in relativ großem Abstand s vom Wien-Filter angeordnet wird, wodurch mit kleinen Ablenkwinkeln die unerwünschten Ionen in einen Bereich der Ebene der Blende 7 abgelenkt werden können, wo sich keine Blendenöffnung 11 befindet. Ein Vergleich der unterschiedlichen Abstände s zwischen Wien-Filter 3 und Ebene der Blende 7 in den Fig. 4 und 5 läßt unschwer erkennen, daß die in diesen Beispielen als unerwünscht anzusehenden Ionen $H_2^+$ und $H_3^+$ bei einer Anordnung gemäß Fig. 5 bei kleinerer Ablenkung von der optischen Achse außerhalb der Blendenöffnung 11 auf die Ebene der Blende 7 treffen als bei einer Anordnung gemäß Fig. 4.

## Patentansprüche

1. Einrichtung zur verkleinernden oder 1 : 1 Ionenprojektionslithographie mit einer Ionenquelle, einer im Strahlengang angeordneten strukturierten Maske sowie einem Substrat, auf dem die Maskenstruktur abgebildet wird, wobei im Strahlengang, zwischen Maske und Substrat, eine Immersionslinse und eine beispielsweise als EINZEL-Linse ausgebildete Projektionslinse und weiters im System zur Massentrennung ein zwischen Ionenquelle und Maske angeordnetes WIEN-Filter samt dazugehöriger Blende, welche die unerwünschten Massen ausblendet, angeordnet sind, dadurch gekennzeichnet, daß die zu dem WIEN-Filter gehörende Blende (7) zwischen Immersionslinse (5) und Substrat (9) in großem Abstand vom WIEN-Filter an einem Ort mit geringem Strahldurchmesser, nämlich an einer Stelle vor dem Kreuzungspunkt der aus der Immersionslinse austretenden Ionenstrahlen, z.B. mit einer Öffnung (11) von 500 $\mu m$, angeordnet ist.

2. Einrichtung nach Anspruch 1, dadurch gekennzeichnet, daß die zum WIEN-Filter gehörende Blende (7) in die Projektionslinse (8) integriert ist.

3. Einrichtung nach Anspruch 1 oder 2, dadurch gekennzeichnet, daß zwischen Ionenquelle (1) und dem WIEN-Filter (3) eine, insbes. als EINZEL-Linse ausgebildete, elektrostatische Vorlinse (2) zur Erzeugung konvergenter Strahlen, deren Kreuzungspunkt im WIEN-Filter (3) liegt, angeordnet ist.

4. Einrichtung nach einem der Ansprüche 1 bis 3, bei der sich eine willkürlich aktivierbare, ein elektrostatisches Feld erzeugende Ablenkeinheit, z.B. ein Multipol, insbes. Oktopol, im Strahlengang befindet, dadurch gekennzeichnet, daß die willkürlich aktivierbare Ablenkeinheit (6) im Strahlengang vor der zum Wien-Filter gehörenden Blende (7) angeordnet ist.

## Claims

1. Apparatus for ion projection lithography on a reduced or 1 : 1 scale including an ion source, a structured mask disposed in the beam path and a substrate on which the mask structure is imaged, whereby arranged in the beam path between the mask and substrate are an immersion lens and a projection lens constructed, for instance, as an EINZEL-lens and further arranged in the system for mass separation there is arranged between ion source and mask a WIEN-filter together with an associated diaphragm intercepting the undesired masses, characterised in that the diaphragm (7) associated with the WIEN-filter is arranged between the immersion lens (5) and substrate (9) at a large distance from the WIEN-filter at a location of small beam diameter, namely at a location before the point of intersection of the ion beams emanating from the immersion lens, e.g. with an opening (11) of 500 $\mu$m.

2. Apparatus as claimed in Claim 1, characterised in that the diaphragm (7) associated with the WIEN-filter is integrated into the projection lens (8).

3. Apparatus as claimed in Claim 1 or 2, characterised in that arranged between the ion source (1) and the WIEN-filter (3) there is an electrostatic fore-lens (2) constructed in particular as an EINZEL-lens, for producing convergent beams whose point of intersections lies within the WIEN-filter (3).

4. Apparatus as claimed in one of Claims 1 to 3 in which disposed in the beam path there is a deflecting unit, e.g. a multipole, particularly an octupole, which produces an electrostatic field and may be activated at will, characterised in that the deflecting unit (6), which may be activated at will, is arranged in the beam path before the diaphragm (7) associated with the WIEN-filter.

**Revendications**

1. Dispositif de lithographie par projection d'ions à échelle réductrice ou à échelle 1 : 1, comportant une source d'ions, un masque à structure disposé dans la trajectoire de rayonnement ainsi qu'un substrat, sur lequel la structure du masque est reproduite, étant disposés sur la trajectoire de rayonnement entre le masque et le substrat, une lentille à immersion et une lentille de projection conformée, par exemple, en lentille de EINZEL et, en outre, dans le système de séparation des masses, un filtre de WIEN disposé entre la source d'ions et le masque accompagné de son diaphragme associé, qui supprime les masses indésirables, caractérisé en ce que le diaphragme (7) appartenant au filtre de WIEN est disposé entre la lentille à immersion (5) et le substrat (9), à une grande distance du filtre de WIEN, en un point de faible diamètre de rayonnement, à savoir en un point situé avant le point d'intersection des rayons d'ions sortant de la lentille à immersion, par exemple avec un ouverture (11) de 500 $\mu$m.

2. Dispositif selon la revendication 1, caractérisé en ce que le diaphragme (7) appartenant au filtre de WIEN est intégré dans le lentille de projection (8).

3. Dispositif selon la revendication 1 ou 2, caractérisé en ce qu'est disposée, entre la source d'ions (1) et le filtre de WIEN (3), une lentille préliminaire (2) électrostatique, conformée en particulier en lentille de EINZEL, destinée à produire des rayons convergents, dont le point d'intersection se trouve dans le filtre de WIEN (3).

4. Dispositif selon l'une des revendications 1 à 3, dans lequel une unité de déviation produisant un champ électrostatique, arbitrairement activable, par exemple un multipôle et, en particulier, un octopôle, se trouve dans la trajectoire de rayonnement, caractérisé en ce que l'unité de déviation (6) arbitrairement activable est disposée, dans la trajectoire de rayonnement, avant le diaphragme (7) appartenant au filtre de WIEN.

*FIG.1*

FIG.1a

EP 0 281 549 B1

FIG.2

FIG.3

FIG.4

FIG.5

8

FIG.6